**Europäisches Patentamt**

**European Patent Office**

**Office européen des brevets**

(19)

(11) Numéro de publication: **0 149 390**
**B1**

(12) **FASCICULE DE BREVET EUROPÉEN**

(45) Date de publication du fascicule du brevet:
08.06.88

(21) Numéro de dépôt: **84402636.9**

(22) Date de dépôt: **18.12.84**

(51) Int. Cl.⁴: **H 01 L 29/80,** H 01 L 29/78,
H 01 L 29/64, H 01 L 29/60

(54) **Transistor à effet de champ, de structure verticale submicronique, et son procédé de réalisation.**

(30) Priorité: **27.12.83 FR 8320840**

(43) Date de publication de la demande:
**24.07.85 Bulletin 85/30**

(45) Mention de la délivrance du brevet:
**08.06.88 Bulletin 88/23**

(84) Etats contractants désignés:
**DE GB NL**

(56) Documents cité:
**EP-A-0 051 504**
**FR-A-2 230 082**
**US-A-4 262 296**

(73) Titulaire: **THOMSON- CSF, 173, Boulevard
Haussmann, F-75379 Paris Cédex 08 (FR)**

(72) Inventeur: **Kohn, Erhard, THOMSON- CSF SCPI
173, bld Haussmann, F-75379 Paris Cedex (FR)**

(74) Mandataire: **Taboureau, James, THOMSON- CSF
SCPI 19, avenue de Messine, F-75008 Paris (FR)**

LIBER, STOCKHOLM 1988

## Description

La présente invention concerne un transistor à effet de champ, de structure verticale et de dimensions submicroniques, fonctionnant en régime balistique ou quasi balistique. Ce transistor est destiné aux hyperfréquences, jusque 100 et 200 GHz, et, de façon à augmenter ses capacités d'amplification et sa puissance, son impedance de sortie est augmentée au moyen d'un découplage entre la grille sur laquelle est appliqué le signal hyperfréquence et drain par une seconde grille c'est un transistor tétrode.

Le transistor selon l'invention est de type métal-semiconducteur, ou métal-isolant-semiconducteur parce qu'il n'est pas envisageable, dans une structure verticale, surtout si elle est submicronique, de réaliser des jonctions pn entre couches de matériaux semiconducteurs sur les flancs d'une mésa. C'est donc un transistor métal-semiconducteur dit Mesfet, ou de type métal-isolant-semiconducteur dit Misfet, mais, en vue de simplifier les explications et les figures, l'invention sera exposée en s'appuyant sur le cas d'un transistor Mesfet.

De la même façon, les transistors hyperfréquences, c'est-à-dire ceux qui travaillent à des fréquences très loin au-delà d'un GHz, sont actuellement réalisés en matériau des groupes III-V, surtout s'ils sont à longueur de grille submicronique. L'invention s'applique egalement aux transistors en silicium, mais un transistor en silicium est loin d'avoir les performances en hyperfréquence d'un transistor en arséniure de gallium, c'est pourquoi l'invention sera exposée en s'appuyant sur le cas d'un transistor en arséniure de gallium GaAs, bien que des matériaux tels que GaA1As, GaOnAs, InP...etc. soient concernés par l'invention.

Un transistor à effet de champ selon la première partie de la revendication 1 et un procédé de réalisation correspondant sont décrits dans EP-A-0 051 504.

Dans un transistor vertical submicronique, l'impédance de sorte entre source et drain est de faible valeur, parce que les transistors submicroniques ont de très petites dimensions de source et drain. Il n'est donc pas possible d'obtenir à travers une couche fine de matériau qui forme la couche active une impédance élevée. Pour augmenter la puissance disponible, l'effet de champ de la grille sur la sortie du transistor qui est cause de cette faible valeur d'impédance, est interrompu, de façon à mieux découpler la grille, qui représente l'entrée du transistor, du drain. Ce découplage est obtenu en interposant entre grille et drain un dispositif développant une second zone de potentiel négatif, non modulée parce quelle est montée en source de courant et commandée par une tension de grille fixe. Ce dispositif de découplage est donc constitué par une seconde électrode de grille, située entre la première grille du transistor et son drain. Dans une structure verticale, les deux grilles sont déposées sur les flancs de la mésa dans laquelle passe le canal: pour une structure submicronique, cette mésa a une hauteur de l'ordre de 0,4 µm, et le procédé selon l'invention décrit la réalisation d'un tel transistor, possédant deux grilles dont l'une est décalée par rapport à l'autre et située entre la grille hyperfréquence et le drain.

De façon plus précise l'invention concerne un transistor à effet de champ, de structure verticale submicronique, comportant un substrat, dont une première face porte une metallisation d'électrode de source et une seconde face porte une couche de matériau semiconducteur dite couche active, supportant elle-même une couche de matériau semiconducteur dite couche de contact et une métallisation d'électrode de drain, une structure mésa étant formée sous le drain en gravant les deux couches semiconductrices et en entaillant au moins partiellement la couche active et deux métallisations de grille étant déposées sur deux flancs opposés de la structure mésa, ce transistor ayant une longueur du canal conducteur dans la couche active inférieure à un micromètre et étant caractérisé en ce que les deux métallisations de grille forment deux grilles différentes décalées, la seconde grille, qui augmente l'impédance de sortie du transistor, étant plus près du drain que la première grille de commande, par rapport à laquelle elle est décalée par l'épaisseur d'une couche isolante déposée au pied et d'un seul côté de la structure mésa.

L'invention sera mieux comprise par la description d'un exemple de réalisation, et par le procédé qui permet de réaliser le transistor selon l'invention, cette description et son procédé s'appuyant sur les figures suivantes qui représentent:

- figure 1: courbes caractéristiques du courant de drain en fonction de la tension de drain, pour différentes tensions de grille, dans un transistor à effet de champ quasi balistique,
- figure 2 schéma synoptique d'un transistor à effet de champ vertical auquel est ajouté un transistor à effet de champ monté en source de courant,
- figure 3: coupe d'un transistor à effet de champ vertical selon l'invention,
- figure 4: schéma équivalent simplifié d'un transistor à effet de champ vertical, (triode)
- figures 5 à 8: différentes étapes de fabrication d'un transistor à effet de champ vertical, submicronique, selon l'invention.

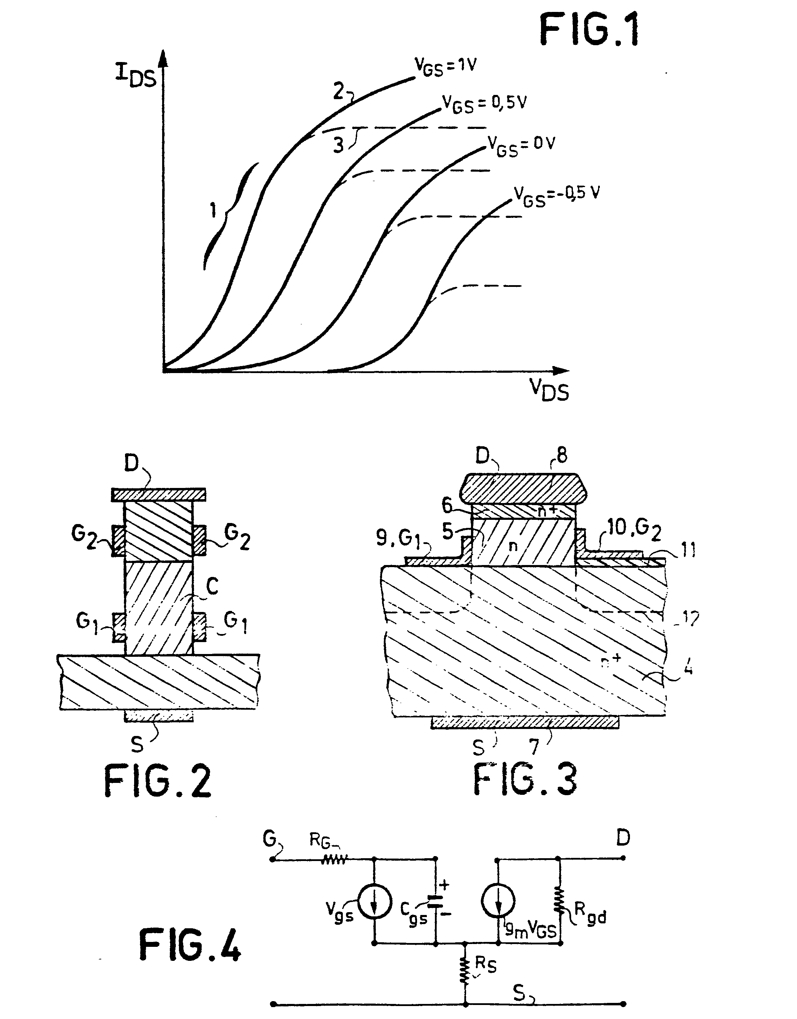

La figure 1 représente les courbes caractéristiques du courant de drain $I_{DS}$ en fonction de la tension de drain $V_{DS}$ pour un transistor à effet de champ vertical submicronique.

Sur ce diagramme sont superposées différentes courbes correspondant à différentes tensions de grille $V_{GS}$, et à titre purement explicatif ont été choisies des tensions de grille positives, nulles, et négatives. Chacune de ces courbes caractéristiques est constituée d'une première partie 1 dite linéaire, qui dans le cas de figure présente augmente fortement en intensité lorsque la tension de drain augmente légèrement la concavité de cette courbe est tournée vers l'axe des ordonnées. Cette forme est opposée à la forme que l'on a l'habitude de rencontrer pour les transistors à effet de champ, les courbes ayant généralement une concavité tournée vers l'axe des abcisses. Ceci est dû au fonctionnement balistique ou quasi balistique du transistor. Plus exactement un transistor ne fonctionne jamais en régime balistique pur, tel que cela existe dans les tubes à vide, mais il fonctionne en un régime presque balistique, définit en anglais par le terme "near ballistic". Du fait du fonctionnement en régime quasi balistique du transistor concerné par l'invention, ces courbes de caractéristiques ont une seconde partie 2 qui a une pente beaucoup trop élevée par rapport à ce que l'on désire obtenir la courbe souhaitée est la courbe 3 représentée en pointillés, qui correspond à une impédance de sortie élevée, et se developpe presque parallèlement à l'axe d'abcisse des tensions de drains, au moins dans la limite inférieure à latension de claquage du transistor.

Il est en effet important pour disposer d'une certaine puissance - compte-tenu des dimensions très petites de ces transistors qui travaillent à 100 ou 200 GHz - que ce transistor présente une résistance de sortie sur son drain, simplement parce que la puissance est proportionnelle à la résistance de sortie multipliée par le carré de l'intensité du courant qui traverse le dispositif. Le courant est limité parce que, en chauffant, il favorise la diffusion des électrons, avec recombinaison, ce qui diminue l'effet balistique. Si la résistance est trop faible, la puissance disponible est faible.

La solution selon l'invention pour augmenter la résistance de sortie d'un transistor à effet de champ submicronique est représentée en figure 2.

Si les transistors a effet de champ sont verticaux, la longueur de grille submicronique présente une impédance de sortie faible, ce qui limite les possibilités d'amplification stable aux hautes fréquences; par contre, ils offrent la possibilité de placer une grille de chaque côté du canal ceci permet d'obtenir une transconductance gm élevée, et de supprimer les effets d'injection de courant dans le substrat, effets que l'on rencontre dans les structures planar submicroniques.

Le schéma synoptique de la figure 2 représente un transistor à effet de champ principal, comportant, outre un substrat, une source S, un canal C commandé par une grille G1 et un drain D. Ce transistor principal est monté en série avec un transistor secondaire qui fait fonction de source de courant: ce transistor secondaire considère le canal C du transistor principal comme étant sa source, le drain D étant commun aux transistors principaux et secondaires, et une grille G2 permet, par l'application par exemple d'un potentiel non modulé, de créer une zone de potentiel négatif propre au transistor secondaire, qui découple ainsi la zone de déplétion modulée du transistor principal et le drain D. Par conséquent, le transistor secondaire intercalé entre la grille G1 et le drain D du transistor principal agit en régulateur de courant, et par effet de découplage entre G1 et D il augmente l'impédance de sortie du transistor principal.

La figure 3 représente comment est réalisé un transistor selon l'invention. Il est bien entendu que cette invention s'applique à un transistor dont la longueur de grille ou de canal est submicronique, c'est-à-dire que la distance entre les deux couches de source et de drain est inférieure à environ 0,4 µm lorsqu'il s'agit de GaAs.

Le transistor selon l'invention comporte un substrat 4, qui est en matériau de type n+, et qui porte une électrode de contact 7: cette électrode portée par le substrat est l'électrode de source, car, comme il a été dit que la seconde grille du transistor doit être plus près du drain, une structure inversée qui porterait la source sur le mésa et le drain au substrat est également envisageable mais difficilement réalisable. Sur le substrat 4 est déposée une couche 5 de matériau dopé de type n qui constitue la couche active, et dans laquelle se développe le canal conducteur de ce transistor vertical. Cette couche S porte elle-même une fine couche 6 en matériau dopé de type n+ qui forme hétérojonction pour injection d'électrons chauds cette fine couche a également pour objet de pouvoir prendre un bon contact pour la métallisation 8 qui constitue le drain du transistor. L'épaisseur de la couche 5 est donc, à l'aplomb du drain, de l'ordre de 0,4 µm.

Dans les couches 6 et 5 est réalisée une mésa, et les électrodes de grille G1 repérée 9 et G2 repérée 10 sont déposées sur deux côtés opposés de cette mésa. Le décalage entre les deux électrodes est obtenu en déposant la seconde électrode G2 sur une épaisseur 11 d'un isolant. En outre les caractéristiques du transistor selon l'invention sont meilleures si une zone 12 implantée est rendue semi-isolante et réalisée dans l'épaisseur de la couche active et en partie dans le substrat, autour du pied de la mésa.

Le fonctionnement d'un transistor triode est montré par la figure 4 qui donne le schéma équivalent simplifié d'un transistor à effet de champ vertical.

Sur ce schéma équivalent, la grille G constitue une entrée du quadrupôle, tandis que le drain constitue une sortie du quadrupôle, la source étant commune aux deux autres entrée et sortie du quadrupôle. La grille a une résistance de grille $R_G$ et il existe une source de tension $V_{GS}$ entre grille et source, une capacité parasite $C_{gs}$ étant parallèle par rapport à cette source de tension. En sortie du transistor, la source de tension est égale à la tension de $V_{GS}$ multipliée par la transconductance gm et cette source de tension est elle-même en parallèle avec une résistance $R_{gd}$. La faible valeur de l'impédance de sortie entre la source et le drain s'explique par un effet de champ de la grille. Ce problème est résolu en augmentant le découplage entre la grille et le drain, ce qui a pour conséquence supplémentaire d'améliorer la stabilité du transistor aux hautes fréquences.

Ce decouplage est obtenu grâce à la deuxième grille G2, repérée 10 sur la figure 3, qui est plus proche du drain que la première grille G1.

Les deux grilles peuvent être polarisées selon deux configurations possibles: dans un premier cas, les deux grilles sont polarisées de façon identique par un potentiel $V_{G2}$, qui est une tension continue, et par une tension à radio fréquence, puisqu'il a été précisé que le transistor selon l'invention concerne des hyperfréquences. Dans ce cas, les deux grilles sont réunies par une métallisation qui permet d'appliquer simultanément la tension de signal hyperfréquence sur les deux grilles.

Dans un deuxième cas, la première grille G1 proche de la source, est polarisée par le signal radio fréquence, et la seconde grille G2 est soumise à un otentiel statique $V_{G2}$: dans ce cas, les deux grilles ne sont pas réunies entre elles.

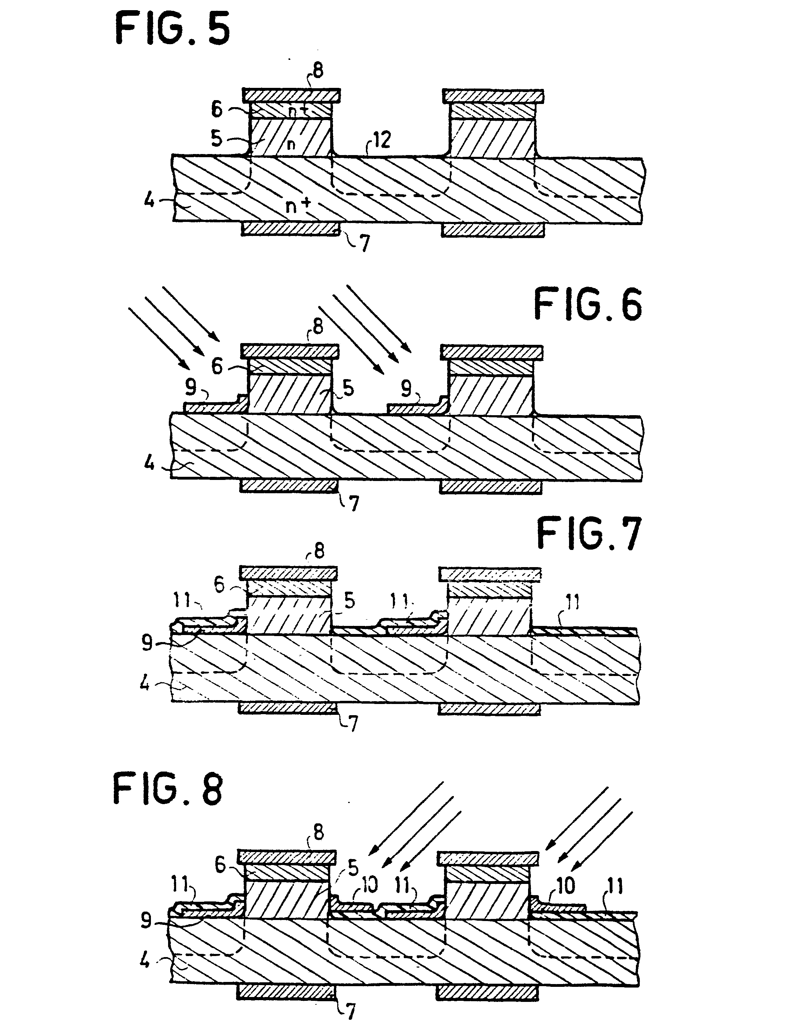

Les figures 5 à 8 représentent les différentes étapes de fabrication d'un transistor à effet de champ selon l'invention.

Dans un premier stade, représenté par la figure 5, on réalise une structure mésa sur un substrat en matériau dopé de type n+. Ce substrat est préférentiellement de type n+ car il n'est pas envisageable de réaliser des transistors hyperfréquences balistiques ou quasi balistiques avec des matériaux de type p. En outre, comme cela a déjà été dit, le substrat est en matériau de type GaAs, GaA1As, InP, GaInP...etc. Sur ce substrat 4, est d'abord déposée, par les moyens bien connus de l'homme de l'art, une couche 5 en matériau de type n et une fine couche 6 en matériau de type n+ formant hétérojonction. L'épaisseur des couches 5 à 6 est en tout cas inférieure ou égale à 1 µm, compte-tenu de la partie de la couche 5 qui s'étend autour des pieds du mésa. Les métallisations 7 de source et 8 de drain sont ensuite réalisées et une implantation crée des zones semi-isolantes 12 autour du pied des mésas.

L'étape suivante, représentée en figure 6, consiste à déposer la première grille G1 repérée 9 par une métallisation qui se fait au moyen d'une source directive, inclinée d'un premier côté par rapport à la structure du transistor. Cette métallisation est représentée symboliquement par des flèches venant de gauche sur la figure 6.

Les premières grilles G1 ou 9 étant réalisées, l'opération suivante, en figure 7, consiste à déposer une couche d'isolant 11 dans le fond des fossés qui séparent les différentes mésas de la plaquette en cours de réalisation: en effet, et cela est évident pour l'homme de l'art, la réalisation de tels transistors se fait par des procédés collectifs et les figures 5 à 8 représentent un fragment d'une rondelle dans laquelle sont réalisés simultanément un grand nombre de transistors c'est pourquoi entre deux mésas il y a un fossé. La nature de l'isolant 11 dépend des caractéristiques que l'on désire pour le transistor, et elle dépend également des matériaux de départ et des conditions dans lesquelles on peut déposer à leur surface, et sans détruire le réseau cristallin, une couche d'isolant. Cet isolant peut être un nitrure de silicium ou d'autres produits.

Enfin, en figure 8, la seconde grille G2 repérée 10, est réalisée par une seconde métallisation orientée, avec la même technique que celle qui a servi à déposer la première grille G1 en figure 6, mais l'orientation est cette fois-ci dirigée sur le flanc de la mésa opposé au flanc qui a déjà reçu la première grille G1. En figure 8, cette métallisation dirigée est symbolisée par des flèches venant de droite.

Chaque transistor ayant ainsi reçu deux métallisations G1 (9), G2 (10), il est évident que la seconde grille G2 qui est supportée par une couche d'isolant 11 est décalée par rapport à la première grille G1, et que cette seconde grille est plus proche du drain que la première grille G1.

A ce stade de fabrication, si le transistor est réalisé comme étant un élément discret, la plaquette est découpée en passant dans les fossés entre deux mésas, et le transistor est monté avec des liaisons électriques sur ces quatre électrodes source, drain et les deux grilles G1 et G2. Si le transistor fait partie d'un circuit intégré, il est bien évident qu'il n'y a pas à ce moment là découpe du transistor.

Le transistor selon l'invention peut également avoir la seconde grille MIS, bien que cela ne soit pas représenté sur les figures 5 à 8: pour réaliser un transistor MIS, il suffit après l'étape de la figure 6, de déposer sur les flancs de la mésa et sur le fond du sillon entre deux mésas une couche d'un isolant, couche sur laquelle est alors déposée la seconde grille G2. L'important étant essentiellement que ce soient les flancs de la mésa qui reçoivent cette couche d'oxyde ou d'isolant puisque le canal conducteur se développe à l'intérieur de la mésa, et non pas à plat parallèlement au substrat, sur les bords latéraux du transistor.

Plusieurs combinaisons sont possibles entre:
- deux grilles MES,
- deux grilles MIS,
- une grille MES et une grille MIS.

Enfin, bien que l'invention ait été exposée en s'appliquant sur le cas simple d'un transistor qui ne comporte qu'une couche de canal entre une électrode de drain et un substrat, qui est toujours nécessaire, l'invention peut s'appliquer à des transistors plus complexes, qui comporteraient davantage de couches de matériaux, telles que des couches de lissage, des couches d'accélération pour obtenir des électrons chauds, ou encore des matériaux plus complexes que ceux qui ont été évoqués. Il est bien entendu que de toute façon ce transistor concerne les matériaux rapides puisque sa fréquence de travail se situe dans une gamme allant jusque 200 GHz.

**Revendications**

1. Transistor à effet de champ, de structure verticale submicronique, comportant un substrat (4), dont une première face porte une métallisation d'électrode de source (7) et une seconde face porte une couche de matériau semiconducteur dite couche active (5), supportant elle-même une couche de matériau semiconducteur dite couche de contact (6) et une métallisation d'électrode de drain (8), une structure mesa étant formée sous le drain (8) en gravant les deux couches semiconductrices (5, 6) et en entaillant au moins partiellement la couche active (5), et deux métallisations de grille (9, 10) étant déposées sur deux flancs opposés de la structure mésa, ce transistor ayant une longueur du canal conducteur dans la couche active (5) inférieure à un micromètre et étant caractérisé en ce que les deux métallisations de grille (9, 10) forment deux grilles différentes (G1, G2) décalées, la seconde grille (G2), qui augmente l'impédance de sortie du transistor, étant plus près du drain (8) que la première grille (G1) de commande, par rapport à laquelle elle est décalée par l'épaisseur d'une couche isolante (11) déposée au pied et d'un seul côté de la structure mésa.

2. Transistor à effet de champ selon la revendication 1, caractérisé en ce que la métallisation (9) de la première grille (G1) se prolonge sur la surface supérieure de la couche active (5) dégagée par la formation de la structure mésa, et en ce que la métallisation (10) de la seconde grille (G2) se prolonge sur la surface de la couche isolante (11) elle-même déposée sur la surface supérieure de la couche active (5).

3. Transistor à effet de champ selon la revendication 1, caractérisé en ce que le substrat (4) et la couche de contact (6) sont en matériau semiconducteur dopé de type n+ et la couche active (5) est en matériau semiconducteur dopé de type n.

4. Transistor à effet de champ selon la revendication 1, caractérisé en ce que le matériau semiconducteur du substrat (4) et des couches (5, 6) est de la famille III-V, tel que GaAs, $A1_x GGa_{1-x}$ As, InP, Ga InP...

5. Transistor à effet de champ selon la revendication 1, caractérisé en ce que le matériau semiconducteur de la couche active (5) est rendu semi-isolant, autour de la structure mésa, par implantation (12).

6. Transistor à effet de champ selon la revendication 1, de type MOSFET ou MISFET, caractérisé en ce qu'une couche de matériau isolant (MIS) ou d'oxyde (MOS) est préalablement déposée sur les flancs de la mésa, avant le dépôt de la couche isolante (11) au pied de la structure mésa, puis des métallisations (9, 10) de grilles (G1, G2), la seconde grille (G2) étant déposée sur la couche isolante (11).

7. Procédé de réalisation d'un transistor à effet de champ de structure verticale submicronique selon la revendication 3 comportant les étapes suivantes:

a) sur un substrat (4) de matériau semiconducteur dopé n+, dépôt d'une couche active (5), dopée n, d'épaisseur inférieur à un micromètre et d'une couche de prise de contact (6), dopée n+; dépôt des métallisations de source (7), sur la face arrière du substrat (4) et de drain (8) sur la couche de prise de contact (6), et gravure d'une structure mésa par attaque partielle des deux couches (5, 6),

- b) dépôt de la première grille (G1) par vaporisation de métal sur un premier flanc de la mésa, selon une méthode non isotropique,

- c) dépôt sur la surface de la couche active (5), dégagée par la formation de la structure mésa, d'une couche d'un matériau isolant (11),

- d) dépôt de la deuxième grille (G2) par vaporisation de métal sur un second flanc de la mésa, opposé au premier flanc, selon une méthode non isotropique.

**Patentansprüche**

1. Feldeffekttransistor mit vertikaler Struktur im Submikronbereich, bestehend aus einem Substrat (4), dessen erste Oberfläche eine Elektrodenmetallisierung für die Quellenelektrode (7) und dessen zweite Oberfläche eine Schicht aus Halbleitermaterial, genannt aktive Schicht (5), trägt, auf der ihrerseits eine Schicht aus Halbleitermaterial, genannt Kontaktschicht (6), sowie eine Elektrodenmetallisierung für die Drainelektrode (8) aufgebracht ist, wobei unter der Drainelektrode (8) eine Mesastruktur durch Ausgravieren der beiden halbleitenden Schichten (5, 6) und durch zumindest partielles Ausschneiden der aktiven Schicht (5) gebildet wird, und daß zwei Gatemetallisierungen (9, 10) auf einander gegenüberliegenden Flanken der Mesastruktur aufgebracht sind, und die Länge des leitenden Kanals in der aktiven Schicht (5) des Transistors unterhalb von 1 Mikrometer liegt, dadurch gekennzeichnet, daß die beiden Gatemetallisierungen (9, 10) zwei verschiedene gegeneinander versetzte Gates (G1, G2) bilden, wobei das zweite Gate (G2), welches die Ausgangsimpedanz des Transistors vergrößert, näher an der Drainelektrode (8) gelegen ist als das erste Steuergate (G1), gegen welches es um die Dicke einer am Fuße und an einer einzigen Seite der Mesastruktur aufgebrachten Isolierschicht (11) versetzt ist.

2. Feldeffekttransistor nach Anspruch 1, dadurch gekennzeichnet, daß sich die Metallisierung (9) des ersten Gates (G1) bis auf die obere, durch die Bildung der Mesastruktur freie legte Fläche der aktiven Schicht (5) erstreckt, und daß sich die Metallisierung (10) des zweiten Gates (G2) über die Oberfläche der Isolierschicht (11) erstreckt, welche ihrerseits auf der oberen Fläche der aktiven Schicht (5) aufgebracht ist.

3. Feldeffekttransistor nach Anspruch 1, dadurch gekennzeichnet, daß das Substrat (4) und die Kontaktschicht (6) aus dotiertem Halbleitermaterial vom n+-Typ besteht und die aktive Schicht (5) aus dotiertem Halbleitermaterial vom n-Typ ist.

4. Feldeffekttransistor nach Anspruch 1, dadurch gekennzeichnet, daß das Halbleitermaterial des Substrats (4) und der Schichten (5, 6) zur Familie III-V gehört und etwa aus GaAs, $A_{1x} Ga_{1-x} As$, InP, GaInP ... besteht.

5. Feldeffekt transistor nach Anspruch 1, dadurch gekennzeich net, daß das Halbleitermaterial der aktiven Schicht um die Mesastruktur herum durch Implantation (12) halbisolierend gemacht ist.

6. Feldeffekttransis tor vom Typ MOSFET oder MISFET nach Anspruch 1, dadurch gekennzeichnet, daß vor dem Aufbringen der Isolierschicht (11) am Fuße der Mesastruktur eine Schicht aus isolierendem (MIS) oder oxidischem (MOS) Material an den Flanken der Mesa aufgebracht und sodann die Metallisierungen (9, 10) der Gates (G1, G2) aufgebracht werden, wobei das zweite Gate (G2) auf die Isolierschicht (11) aufgebracht wird.

7. Verfahren zur Herstellung eines Feldeffekttransistors mit vertikaler Struktur im Submikronbereich, nach Anspruch 3, bestehend aus den folgenden Schritten:

- a) Aufbringen einer n-dotierten aktiven Schicht (5) von weniger als 1 Mikrometer Dicke und einer n+-dotierten Kontaktschicht (6) auf ein n+-dotiertes Substrat (4) aus Halbleitermaterial; Aufbringen der Metallisierungen (7) der Quellenelektrode auf der abgekehrten Seite des Substrats (4) und der Drainelektrode (8) auf der Kontaktschicht (6), und Herausarbeiten einer Mesastruktur durch partielles Abtragen der beiden Schichten (5, 6),

- b) Aufbringen des ersten Gates (G1) durch Aufdampfen von Metall auf eine erste Flanke der Mesa nach einem nichtisotropen Verfahren,

- c) Aufbringen einer Schicht aus isolierendem Material (11) auf die durch die Bildung der Mesastruktur freigelegte Oberfläche der aktiven Schicht (5),

- d) Aufbringen ds zweiten Gates (G2) durch Aufdampfen von Metall auf eine zweite, der ersten gegenüberliegende Flanke der Mesa, nach einem nichtisotropen Verfahren.


**Claims**

1. A field effect transistor having a vertical structure at the submicron scale, comprising a substrate (4), a first surface of which has a source electrode (7) metal layer and a second surface of which has a semiconductor material layer referred to as active layer (5), having in turn a semiconductor material layer referred to as contact layer (6) and a drain electrode (8) metal layer, a mesa structure being formed below the drain (8) by engraving the two semiconductor layers (5, 6) and by intersecting at least partially the active layer (5), and two gate metal layers (9, 10) being deposited on two opposing flanks of the mesa structure, and the length of the conductive channel present in the active layer (5) of the transistor measuring less than one micrometer, characterized in that the two gate metal layers (9, 10) constitute two different dislocated gates (G1, G2), the second gate (G2), which increases the output impedance of the transistor, being placed nearer to the drain (8) than the first control gate (G1), in relation to which it is dislocated by a distance equal to the thickness of an insulation layer (11) deposited at the base and at only one side of the mesa structure.

2. A field effect transistor according to claim 1, characterized in that the metal layer (9) of the first gate (G1) extends over the upper surface of the active layer (5) being denuded by the formation of the mesa structure, and that the metal layer (10) of the second gate (G2) extends over the surface of the insulating layer (11), which in turn is deposited on the upper surface of the active layer (5).

3. A field effect transistor according to claim 1, characterized in that the substrate (4) and the contact layer (6) consist of a doped n+-type semiconductor material and that the active layer (5) consists of a doped n-type semiconductor material.

4. A field effect transistor according to claim 1, characterized in that the semiconductor material of the substrate (4) and of the layers (5, 6) belongs to the III-V family, such as GaAs, $A_{1x} Ga_{1-x} As$, InP, GaInP ...

5. A field effect transistor according to claim 1, characterized in that the semiconductor material of the active layer (5) is made semi-insulating around the mesa structure by implantation (12).

6. A field effect transistor according to claim 1 of the MOSFET or MISFET type, characterized in that prior to depositing the insulating layer (11) at the base of the mesa structure, an insulating layer (MIS) or an oxide layer (MOS) is deposited on the mesa flanks, and that hereafter the metal layers (9, 10) of the gates (G1, G2) are formed, the second gate (G2) being deposited over the insulating layer (11).

7. A method for producing a field effect transistor having a vertical structure at the submicron scale, according to claim 3, characterized in that it comprises the following steps:

- a) deposition of a n-doped active layer (5) having a thickness of less than one micrometer and of a n+-doped contact layer (6) on a subtrate (4) of n+-doped semiconductor material; deposition of the source (7) metal layers on the rear face of the substrate (4) and of the drain (8) on the contact layer (6), and engraving of a mesastructure by partially attacking the two layers (5, 6),

- b) deposition of the first gate (G1) by metal vaporisation on a first flank of the mesa structure accoding to a non-isotropic method,

- c) deposition of a layer of insulating material (11) on the surface of the active layer (5) laid open by the formation of the mesa structure,

- d) deposition of the second gate (G2) by metal vaporisation on a second flank of the mesa, opposing the first flank, according to a non-isotropic method.

# FIG.1

$I_{DS}$

$V_{GS} = 1V$

2

$V_{GS} = 0,5V$

3

$V_{GS} = 0V$

1

$V_{GS} = -0,5V$

$V_{DS}$

D

$G_2$ $G_2$

C

$G_1$ $G_1$

S

## FIG.2

D 8

6 n+

5

9,$G_1$ n 10,$G_2$ 11

12

n+ 4

S 7

## FIG.3

G $R_G$ D

$V_{gs}$ $C_{gs}$ + − $g_m V_{GS}$ $R_{gd}$

$R_S$

S

## FIG.4

# FIG. 5

# FIG. 6

# FIG. 7

# FIG. 8